# EUROPEAN PATENT APPLICATION

(11) **EP 4 525 294 A1**
(43) Date of publication of application: **19.03.2025**
(21) Application number: 24186496.6
(22) Date of filing: 04.07.2024
(51) Int. Cl.: H02M 7/5395, H02S 40/30, H02S 40/32, H02S 50/00, H03K 17/16

(54) **CONTROL DEVICE, SYSTEM AND STORAGE MEDIUM**

(30) Priority: 12.09.2023 JP 2023147535
(71) Applicant: Kabushiki Kaisha Toshiba, Tokyo 105-0023 (JP)
(72) Inventor: OKUNI, Hidenori, Minato-ku, Tokyo (JP); SAKAMOTO, Takafumi, Minato-ku, Tokyo (JP); NISHIKAWA, Masaki, Minato-ku, Tokyo (JP); TANIGUCHI, Kentaro, Minato-ku, Tokyo (JP)
(74) Representative: Hoffmann Eitle

(57) **Abstract**

According to one arrangement, a control device (3) is connected to at least three or a plurality of switching controllers (2_1, 2_2, 2_3, 2_4) converting AC signals into DC signals and outputting the DC signals or converting DC signals into AC signals and outputting the AC signals. The control device (3) is configured to generate the same number of carrier frequencies (f_1, f_2, f_3, f_4) as the switching controllers (2_1, 2_2, 2_3, 2_4). The control device (3) is configured to rearrange the generated carrier frequencies (f_1, f_2, f_3, f_4) in ascending or descending order and calculate a difference (Δf_1_2, Δf_2_3, Δf_3_4) between two adjacent carrier frequencies among the generated carrier frequencies (f_1, f_2, f_3, f_4). The control device (3) is configured to, if all the calculated differences (Δf_1_2, Δf_2_3, Δf_3_4) between adjacent carrier frequencies are different, set one of the generated carrier frequencies (f_1, f_2, f_3, f_4) as the carrier frequency of one of the switching controllers (2_1, 2_2, 2_3, 2_4) in order.

## Description

### FIELD

The present disclosure relates to a control device, a system and a storage medium.

### BACKGROUND

In recent years, power generation methods using renewable energy such as photovoltaic power generation and wind power generation, have become increasingly prevalent. In accordance with this trend, a large number of power conditioners (PCS: power conditioning subsystems) including inverter circuits to convert DC voltage generated using renewable energy into AC voltage, have been installed within a certain range.

By the way, the inverter circuits in the above-mentioned PCS generate electromagnetic noise due to switching operations. When a number of such inverter circuits are installed within a certain range, a phenomenon that electromagnetic noise generated by each inverter circuit interferes with each other and intensifies each other may occur. For this reason, realizing a new technology that can suppress the increase in electromagnetic noise observed due to this phenomenon is desired.

### BRIEF DESCRIPTION OF THE DRAWINGS

FIG. 1 is a diagram showing a schematic configuration example of a switching system according to an arrangement.
FIG. 2 is a diagram showing a detailed configuration of a switching controller according to the arrangement.
FIG. 3 is a diagram showing a detailed configuration of the switching control module included in the switching controller according to the arrangement.
FIG. 4 is a chart illustrating a process of generating PWM signals performed by a PWM signal generator shown in FIG. 3.
FIG. 5 is a flowchart showing an operation example of a central control device according to the arrangement.
FIG. 6 is a chart illustrating the first comparative example.
FIG. 7 is a graph illustrating a noise enhancement effect in the configuration according to the first comparative example.
FIG. 8 is a diagram illustrating the effect of the central control device according to the arrangement.
FIG. 9 is a graph illustrating the noise enhancement effect in the configuration according to the arrangement.
FIG. 10 is a diagram illustrating another operation example of the central control device according to the arrangement.
FIG. 11 is a flowchart showing an operation example of the central control device according to a first modified example.
FIG. 12 is a diagram illustrating the second comparative example.
FIG. 13 is a flowchart showing an operation example of the central control device according to a second modified example.

### DETAILED DESCRIPTION

According to one arrangement, a control device is connected to at least three or a plurality of switching controllers converting AC signals into DC signals and outputting the DC signals or converting DC signals into AC signals and outputting the AC signals. The control device is configured to generate the same number of carrier frequencies as the switching controllers. The control device is configured to rearrange the generated carrier frequencies in ascending or descending order and calculate a difference between two adjacent carrier frequencies among the generated carrier frequencies. The control device is configured to, if all the calculated differences between adjacent carrier frequencies are different, set one of the generated carrier frequencies as the carrier frequency of one of the switching controllers in order.

Embodiments will be described hereinafter with reference to the accompanying drawings.

The disclosure is merely an example and the invention is not limited by contents described in the arrangements described below. Modification which is easily conceivable by a person of ordinary skill in the art comes within the scope of the disclosure as a matter of course. In order to make the description clearer, the sizes, shapes and the like of the respective parts may be changed and illustrated schematically in the drawings as compared with those in an accurate representation. Constituent elements corresponding to each other in a plurality of drawings are denoted by like reference numerals and their detailed descriptions may be omitted unless necessary.

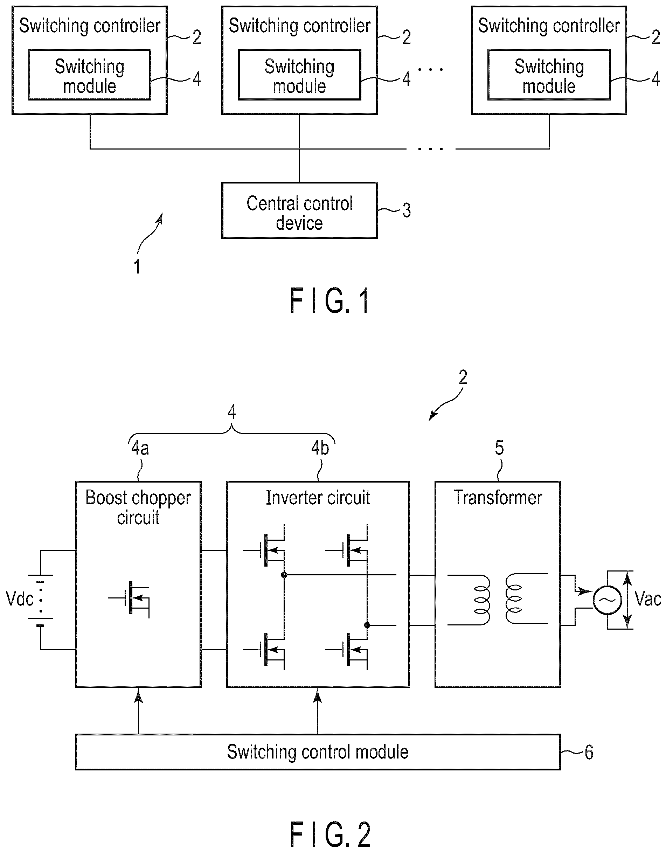

FIG. 1 is a diagram showing a schematic configuration example of a switching system 1 according to an arrangement. As shown in FIG. 1, the switching system 1 comprises a plurality of switching controllers 2 and a central control device 3. The central control device 3 may be simply referred to as a control device. Incidentally, the number of switching controllers 2 included in the switching system 1 may be any number as long as the number is at least three or more.

Each of the plurality of switching controllers 2 comprises a switching module 4 and performs switching control to turn on and off the switching module 4 in its own device at predetermined timing.

Each of the switching controllers 2 is, for example, a power conversion device that converts DC voltage generated by a renewable energy power generation device, such as a photovoltaic (PV) device, into AC voltage. This type of power conversion device is also referred to as a power conditioner (PCS: power conditioning subsystem). Incidentally, the power conversion device may have a mode of converting DC voltage to AC voltage (in other words, a mode of converting DC signals to AC signals) and a mode of converting AC voltage to DC voltage (in other words, a mode of converting AC signals to DC signals).

The central control device 3 is connected to the plurality of switching controllers 2 to control the operations of the plurality of switching controllers 2. More specifically, the central control device 3 generates control parameters on timing at which the switching controller 2 performs a switching operation, for each switching controller 2, and supplies (notifies) the parameters to the switching controller 2. Incidentally, the control parameters may be referred to as control information.

For example, the central control device 3 generates a first control parameter on the timing at which one of the plurality of switching controllers 2 performs the switching operation and supplies a second control parameter on the timing at which another one of the plurality of switching controllers 2 performs the switching operation. The central control device 3 supplies the first control parameter to one of the plurality of switching controllers 2 described above and supplies the second control parameter to another one of the plurality of switching controllers 2 described above.

One of the plurality of switching controllers 2 described above performs switching control of the switching module 4 in its own device, based on the first control parameter supplied from the central control device 3. Similarly, another one of the plurality of switching controllers 2 described above performs switching control of the switching module 4 in its own device, based on the second control parameter supplied from the central control device 3.

By the way, the switching controller 2 shown in FIG. 1 performs the switching operation, and can be thereby a noise source which generates electromagnetic noise. A value of electromagnetic noise generated from one switching controller 2 in accordance with the switching operation of the switching controller 2 and then observed is assumed to be "1", and a situation that N switching controllers 2 are arranged in close proximity to each other is also assumed.

In such a situation, for example, when the electromagnetic noise generated from each of the N switching controllers 2 is uncorrelated, each of the values of the electromagnetic noise generated from and observed by the respective switching controllers 2 remains "1".

In contrast, in the above-described situation, when the timing of performing the switching operations by the N switching controllers 2 coincides, the electromagnetic noise generated by each of the switching controllers 2 remains unchanged, but each of the values of the electromagnetic noise generated by the respective switching controllers 2 and then observed is emphasized to "N times", depending on the position where the electromagnetic noise is observed. In addition, when not only the timing at which the N switching controllers 2 perform the switching operations, but the waveform shapes (frequency characteristics) of the electromagnetic noise generated from the respective switching controllers 2 further match, each of the values of the electromagnetic noise generated from the respective switching controllers 2 and then observed is emphasized to "N x N times", depending on the position where the electromagnetic noise is observed.

Thus, in a situation in which a plurality of noise sources are arranged in close proximity, the electromagnetic noise generated from each of the plurality of noise sources may interfere with each other and intensify each other. In this case, such a phenomenon is referred to as a "noise enhancement effect".

Therefore, the central control device 3 according to the present arrangement controls the operation of each switching controller 2 so as to suppress the electromagnetic noise generated from each of the plurality of switching controllers 2 from increasing due to the above-described noise enhancement effect and then being observed. More specifically, the central control device 3 generates control parameters different from each other for each of the plurality of switching controllers 2 (or a plurality of switching controllers 2 that may cause the noise enhancement effect) connected to its own device, and supplies the control parameters to the switching controllers 2.

FIG. 2 is a diagram showing a detailed configuration of the switching controller 2 according to the present arrangement. Each of the plurality of switching controllers 2 shown in FIG. 1 has the same configuration.

As shown in FIG. 2, the switching controller 2 comprises a switching module 4, a transformer 5, and a switching control module 6.

The switching module 4 includes one or more switching elements and includes, for example, a boost chopper circuit 4a and an inverter circuit 4b. The boost chopper circuit 4a converts the voltage amplitude of the input DC voltage. The inverter circuit 4b generates AC voltage by switching turning on and off the switching element in the own circuit, based on a pulse width modulation (PWM) signal generated using a carrier signal and a reference signal, which will be described below. Incidentally, the elements included in the switching module 4 are not limited to the boost chopper circuit 4a and the inverter circuit 4b described above, but may include other elements that perform conversion of DC/AC, and conversion of voltage, current, frequency, number of phases, and the like, for example, in a state of suppressing the power loss. More specifically, the switching module 4 may include a converter circuit.

The transformer 5 converts the voltage amplitude of the AC voltage to generate, for example, a commercial power supply voltage of 100 V.

The switching control module 6 performs switching control to turn on and off the switching module 4 at predetermined timing. In other words, the switching control module 6 controls the operations of the boost chopper circuit 4a and the inverter circuit 4b included in the switching module 4.

The switching control module 6 may be a semiconductor chip which performs digital signal processing, such as a central processing unit (CPU) or a digital signal processor (DSP), or a discrete digital circuit component, or may be a semiconductor chip which performs analog signal processing, or a discrete analog circuit component.

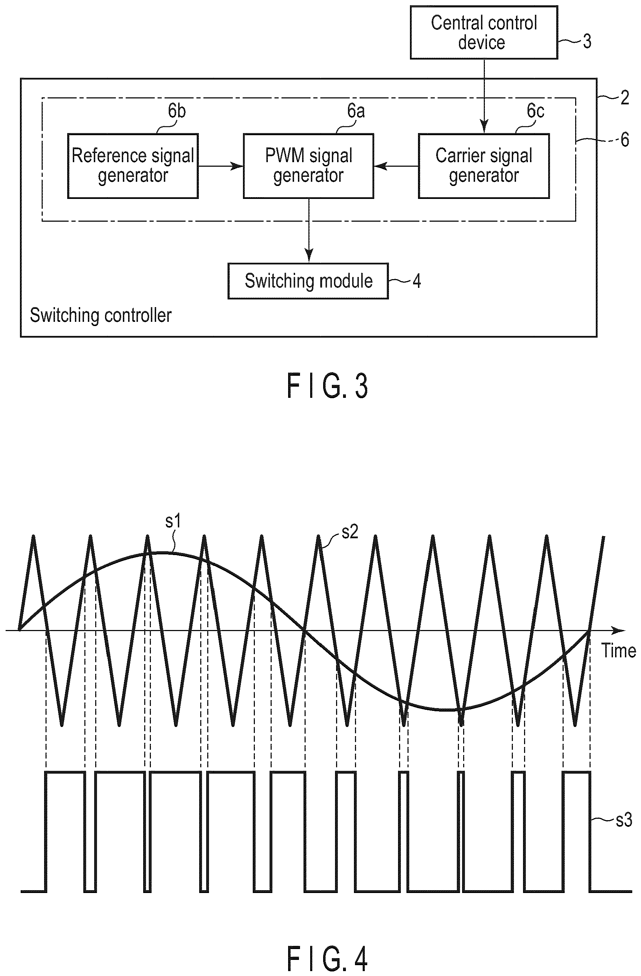

FIG. 3 is a diagram showing a detailed configuration of the switching control module 6 included in the switching controller 2 according to the present arrangement. As shown in FIG. 3, the switching control module 6 includes a PWM signal generator 6a, a reference signal generator 6b, and a carrier signal generator 6c.

The PWM signal generator 6a generates PWM signals to control turning on/off the switching module 4. Although described below in detail, the PWM signal generator 6a generates PWM signals by comparing the magnitude in reference signals generated by the reference signal generator 6b and the magnitude in carrier signals generated by the carrier signal generator 6c.

The reference signal generator 6b generates compensation values to make the AC voltage output from the switching module 4 correspond to a target value and generates the reference signals, based on the compensation values. The generated reference signals are sent to the PWM signal generator 6a.

The carrier signal generator 6c generates the carrier signals, based on the control parameters supplied from the central control device 3. More specifically, the carrier signal generator 6c generates the carrier signals having at least one of the frequency or phase indicated by the control parameters supplied from the central control device 3. The generated carrier signals are sent to the PWM signal generator 6a.

In the present arrangement, it is assumed that the control parameters supplied from the central control device 3 include a signal obtained by modulating the carrier frequency, which is the frequency of the carrier signal. In other words, it is assumed that the control parameter supplied from the central control device 3 indicates the carrier frequency.

Incidentally, the control parameter may indicate not only the carrier frequency, but also the phase of the carrier signal as described above. In addition, the control parameter may further indicate, for example, a waveform shape, a signal amplitude and the like of the carrier signal, in addition to the carrier frequency and phase.

In addition, in the present arrangement, it is assumed that the carrier signal generated by the carrier signal generator 6c is a triangular wave signal, but the carrier signal generated by the carrier signal generator 6c may have any waveform shape of, for example, a saw wave signal, a sine wave signal, a square wave signal, or the like.

FIG. 4 is a chart illustrating a process of generating the PWM signal, which is performed by the PWM signal generator 6a shown in FIG. 3.

A reference signal s1 generated by the reference signal generator 6b has a frequency similar to the frequency (e.g., 50 Hz to 60 Hz) of the AC voltage output from the switching module 4. In addition, a carrier signal s2 generated by the carrier signal generator 6c is a signal having a frequency much higher than the reference signal s1 and is, for example, a triangular wave signal as described above.

For example, the PWM signal generator 6a sets the PWM signal to a high level when a signal amplitude of the reference signal s1 is larger than that of the carrier signal s2, and sets the PWM signal to a low level when the signal amplitude of the reference signal s1 is smaller than or equal to that of the carrier signal s2. According to this, a PWM signal s3 having a pulse width which varies as shown in FIG. 4 is generated. The generated PWM signal s3 is sent to the switching module 4.

The switching module 4 performs a switching operation to switch turning on/off one or more switching elements included in the switching module 4, based on the PWM signal s3 from the PWM signal generator 6a.

The central control device 3 can control the pulse width of the PWM signal s3 by controlling at least one of the frequency or the phase of the carrier signal s2. The central control device 3 according to the present arrangement controls the timing of generation of electromagnetic noise from a plurality of switching controllers 2 by controlling the frequency of the carrier signal s2 and controlling the pulse width of the PWM signal s3.

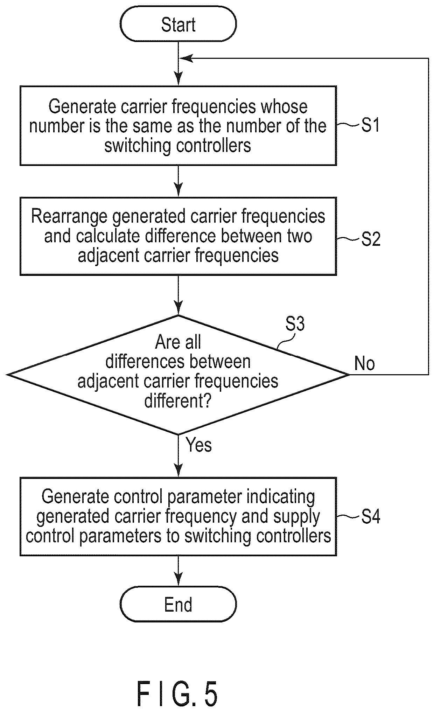

FIG. 5 is a flowchart showing an operation example of the central control device 3 according to the present arrangement. Incidentally, a sequence of operations shown in FIG. 5 is performed, for example, before the plurality of switching controllers 2 connected to the central control device 3 start the operation.

First, the central control device 3 generates carrier frequencies within the range where the plurality of switching controllers 2 connected to the own device can all operate (or the carrier frequencies within the range where the plurality of switching controllers 2 that may cause noise enhancement effect can all operate), i.e., values of the same number of carrier frequencies (hereinafter simply referred to as "carrier frequencies") as the number of the switching controllers 2 (step S1).

For example, the central control device 3 randomly generates the same number of carrier frequencies as the number of switching controllers 2 using a random number generator. Incidentally, the carrier frequencies within the range where all of the plurality of switching controllers 2 can operate vary depending on, for example, the performance of the switching controllers 2.

Then, the central control device 3 rearranges the carrier frequencies generated in the process of step S1 in ascending (or descending) order, and calculates the difference between two adjacent carrier frequencies (hereinafter referred to as "difference between adjacent carrier frequencies") in order (step S2).

The central control device 3 confirms whether all the differences between adjacent carrier frequencies calculated in the process of step S2 are different values (step S3).

If it is confirmed in the process of step S3 that all the differences between adjacent carrier frequencies are not different values, i.e., at least two of the differences between adjacent carrier frequencies show the same value (No in step S3), the process of step S1 described above is performed again and the same number of carrier frequencies as the number of switching controllers 2 are generated again.

In contrast, if it is confirmed in the process of step S3 that all the differences between adjacent carrier frequencies are different values (Yes in step S3), the central control device 3 assigns (sets) each carrier frequency generated in the process of step S1 to the plurality of switching controllers 2 connected to the own device in order. After that, the central control device 3 generates a control parameter indicating the assigned carrier frequency for each switching controller 2, supplies the control parameters to the switching controllers 2 (step S4), and completes the series of operations.

Incidentally, the central control device 3 may perform the series of operations shown in FIG. 5 at each preset time interval and update the control parameter supplied to each switching controller 2.

In addition, in the above-described process of step S3, it has been described that whether or not all the differences between adjacent carrier frequencies calculated in the process of step S2 are different values is confirmed. The process is not limited to this, but, for example, it may be allowed that the differences between adjacent carrier frequencies in a predetermined rate, of all the differences between adjacent carrier frequencies, are the same or that a predetermined number of the differences between adjacent carrier frequencies, of all the differences between adjacent carrier frequencies, are the same. For example, if two of the differences between adjacent carrier frequencies indicate the same values, the central control device 3 may allow this and perform the above-described process in step S4. If three or more of the differences between adjacent carrier frequency differences indicate the same values, the central control device 3 may not allow this but perform the above-described process of step S1 again.

Advantages of (the switching system 1 including) the central control device 3 according to the present arrangement will be described below, using a first comparative example. Incidentally, the first comparative example is intended to describe some of the advantages that can be achieved by the central control unit 3 according to the present arrangement, but the common advantages in the present arrangement and the first comparative example are not excluded from the scope of the present invention.

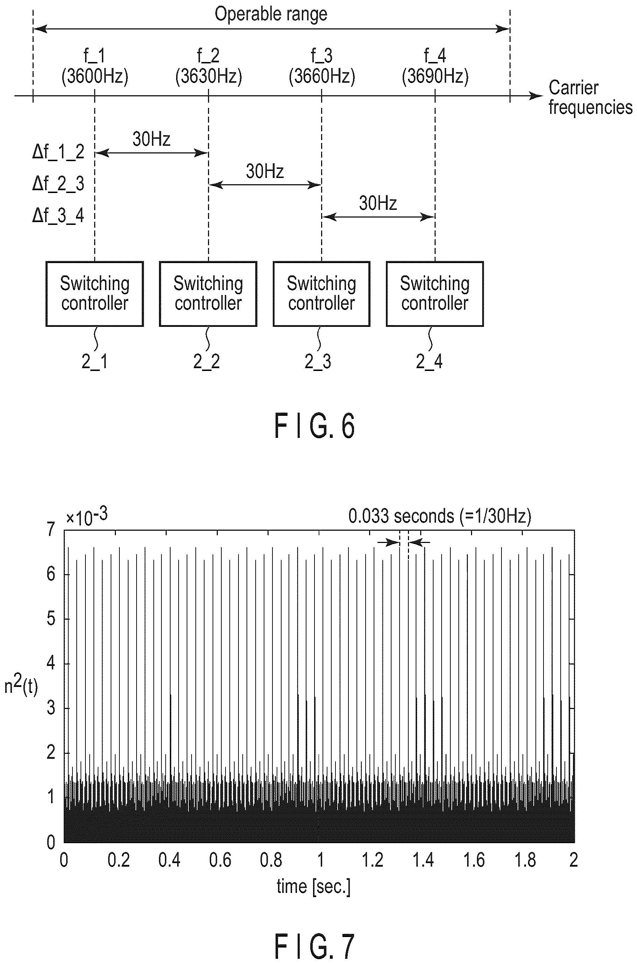

FIG. 6 is a chart illustrating the first comparative example. In the first comparative example, it is assumed that the carrier frequencies set such that all the differences between adjacent carrier frequencies are equal to one another are assigned to four switching controllers 2_1 to 2_4 having the positional relationship shown in FIG. 6, respectively.

More specifically, the switching controller 2_1, which is adjacent to the switching controller 2_2, is assigned a carrier frequency f_1 of 3,600 Hz. The switching controller 2_2, which is adjacent to the switching controllers 2_1 and 2_3, is assigned a carrier frequency f_2 of 3,630 Hz. The switching controller 2_3, which is adjacent to the switching controllers 2_2 and 2_4, is assigned a carrier frequency f_3 of 3,660 Hz. The switching controller 2_4, which is adjacent to the switching controller 2_3, is assigned a carrier frequency f_4 of 3,690 Hz. In other words, in the first comparative example, as shown in FIG. 6, it is assumed that each of difference Δf_1_2 between the carrier frequencies assigned to the adjacent switching controllers 2_1 and 2_2, difference Δf_2_3 between the carrier frequencies assigned to the adjacent switching controllers 2_2 and 2_3, and difference Δf_3_4 between the carrier frequencies assigned to the adjacent switching controllers 2_3 and 2_4 is 30 Hz, and that all the differences between adjacent carrier frequencies are equal.

In this case, the four switching controllers 2_1 to 2_4 simultaneously emit the electromagnetic noise at relatively short intervals, and generate the noise enhancement effect in a cycle that is the reciprocal of the greatest common divisor of the difference between adjacent carrier frequencies. More specifically, the electromagnetic noise emitted from the switching controllers 2_1 to 2_4 generate a noise enhancement effect of mutually interfering and strengthening each other in a cycle of approximately 0.033 seconds (= 1/30 Hz), as shown in FIG. 7. Incidentally, in the graph shown in FIG. 7, a horizontal axis indicates the time while a vertical axis indicates a square value of time waveform n(t) of the electromagnetic noise emitted from the switching controllers 2_1 to 2_4.

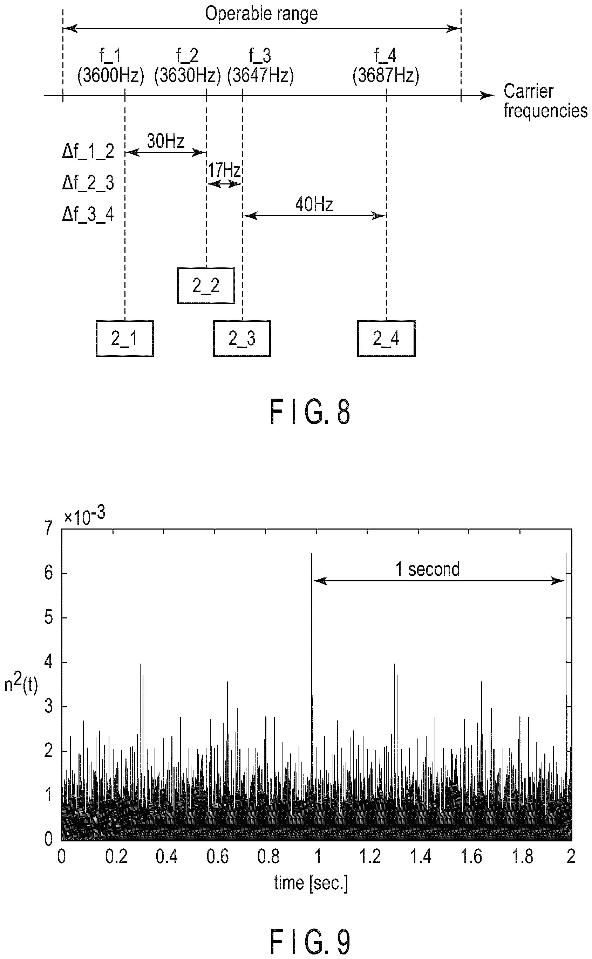

In contrast, in the switching system 1 of the present arrangement, the carrier frequencies which are set such that all the differences between adjacent carrier frequencies are different can be assigned to the four switching controllers 2_1 to 2_4, as described above. More specifically, the switching controller 2_1 is assigned 3,600 Hz as the carrier frequency f_1, the switching controller 2_2 is assigned 3,630 Hz as the carrier frequency f_2, the switching controller 2_3 is assigned 3,647 Hz as the carrier frequency f_3, and the switching controller 2_4 is assigned 3,687 Hz as the carrier frequency f_4, as shown in FIG. 8. In other words, in the present arrangement, the carrier frequencies f_1 to f_4 which are set such that all differences Δf_1_2, Δf_2_3 and Δf_3_4 between adjacent carrier frequencies are different from one another can be assigned to the switching controllers 2_1 to 2_4, as shown in FIG. 8.

According to this, the cycle in which the electromagnetic noises emitted from the switching controllers 2_1 to 2_4 mutually interfere and strengthen each other (i.e., the cycle in which the noise enhancement effect occurs) can be made longer than that in the first comparative example. More specifically, the cycle of occurrence of the noise enhancement effect can be made to one second, and the electromagnetic noise per unit time can be reduced, as shown in FIG. 9.

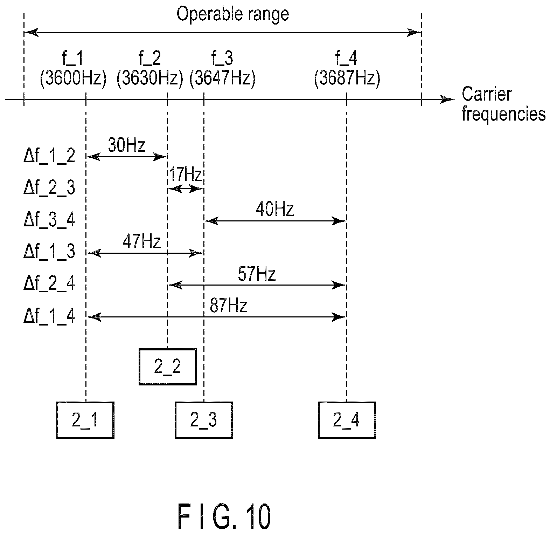

Incidentally, the central control device 3 according to the present arrangement may execute a process of calculating all the differences between each carrier frequency generated in the process of step S1 and confirming whether all the calculated differences between each carrier frequency are different values, instead of performing the processes of steps S2 and S3 shown in FIG. 5. In other words, the central control device 3 may confirm whether not only the differences Δf_1_2, Δf_2_3, and Δf_3_4 between adjacent carrier frequencies, but also the differences between carrier frequencies which are not adjacent (for example, the differences Δf_1_3, Δf_2_4, Δf_1_4 between the carrier frequencies shown in FIG. 10), among the carrier frequencies generated in the process of step S1, are different, as shown in FIG. 10. According to this, the carrier frequencies which are set such that all the differences between the carrier frequencies are different can be assigned to the switching controller 2, the same advantages as those described above can be obtained, or the cycle of occurrence of the noise enhancement effect can be made longer and the electromagnetic noise per unit time can be more reduced.

Alternatively, the central control device 3 may randomly generate the same number of carrier cycles as the number of switching controllers 2 connected to the own device, instead of performing the process of step S1 shown in FIG. 5. In this case, the central control device 3 performs the processes in steps S2 and S3 shown in FIG. 5 after converting the generated carrier cycles into the carrier frequencies. As a result, if it is confirmed that all the differences between adjacent carrier frequencies are different values, the central control device 3 generates the control parameters indicating the carrier cycles corresponding to the respective carrier frequencies, and supplies the control parameters to the switching controllers 2.

Modified examples will be described below.

### (First Modified Example)

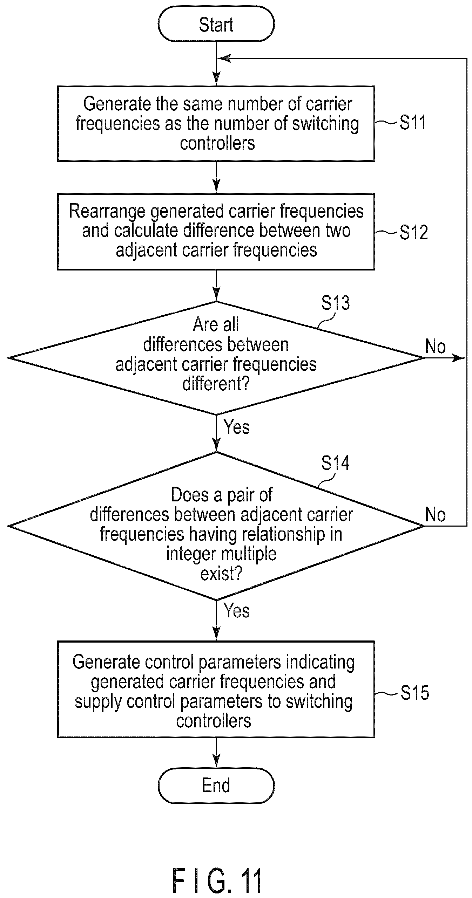

FIG. 11 is a flowchart showing an operation example of the central control device 3 according to the first modified example. Incidentally, a sequence of operations shown in FIG. 11 is performed, for example, before the plurality of switching controllers 2 connected to the central control device 3 start the operation.

First, the central control device 3 generates carrier frequencies within the range where the plurality of switching controllers 2 connected to the own device can all operate (or the carrier frequencies within the range where the plurality of switching controllers 2 that may cause noise enhancement effect can all operate), i.e., values of the same number of carrier frequencies as the number of the switching controllers 2 (step S11).

For example, the central control device 3 randomly generates the same number of carrier frequencies as the number of switching controllers 2 using a random number generator. Incidentally, the carrier frequencies within the range where all of the plurality of switching controllers 2 can operate vary depending on, for example, the performance of the switching controllers 2.

Then, the central control device 3 rearranges the carrier frequencies generated in the process of step S11 in ascending (or descending) order, and calculates the difference between adjacent carrier frequencies in order (step S12).

The central control device 3 confirms whether all the differences between adjacent carrier frequencies calculated in the process of step S12 are different values (step S13).

If it is confirmed in the process of step S13 that all the differences between adjacent carrier frequencies are not different values, i.e., at least two of the differences between adjacent carrier frequencies show the same value (No in step S13), the process of step S11 described above is performed again and the same number of carrier frequencies as the number of switching controllers 2 are generated again.

In contrast, if it is confirmed in the process of step S13 that all the differences between adjacent carrier frequencies are different values (Yes in step S13), the central control device 3 confirms whether a pair of the differences between adjacent carrier frequencies having a relationship in integer multiple does not exist among the differences between adjacent carrier frequencies, which are calculated in the process of step S12 (step S14).

If it is confirmed in the process of step S14 that a pair of the differences between adjacent carrier frequencies having a relationship in integer multiple exists (No in step S14), the above-described process in step S11 is performed again, and the same number of carrier frequencies as the number of switching controllers 2 are generated again.

In contrast, if it is confirmed in the process of step S14 that no pairs of the differences between adjacent carrier frequencies having a relationship in integer multiple exist (Yes in step S14), the central control device 3 assigns (sets) each carrier frequency generated in the process of step S11 to the plurality of switching controllers 2 connected to the own device in order. After that, the central control device 3 generates a control parameter indicating the assigned carrier frequency for each switching controller 2, supplies the control parameters to the switching controllers 2 (step S15) and ends the series of operations.

Incidentally, the central control device 3 may perform the series of operations shown in FIG. 11 at each preset time interval to update the control parameters supplied to each switching controller 2.

In addition, in the above-described process of step S13, it has been described that whether or not all the differences between adjacent carrier frequencies calculated in the process of step S12 are different values is confirmed. The process is not limited to this, but, for example, it may be allowed that the differences between adjacent carrier frequencies in a predetermined rate, of all the differences between adjacent carrier frequencies, are the same or that a predetermined number of the differences between adjacent carrier frequencies, of all the differences between adjacent carrier frequencies, are the same.

For example, if two of the differences between adjacent carrier frequencies indicate the same values, the central control device 3 may allow this and perform the above-described process in step S14. If three or more of the differences between adjacent carrier frequency differences indicate the same values, the central control device 3 may not allow this but perform the above-described process of step S11 again.

Similarly, in the above-described process of step S14, it has been described that whether the pair of the differences between adjacent carrier frequencies having the relationship in integer multiple does not exist among the differences between adjacent carrier frequencies calculated in the process of step S12 is confirmed. The process is not limited to this, but, for example, it may be allowed that the differences between adjacent carrier frequencies in a predetermined rate, of all the differences between adjacent carrier frequencies, have the relationship in integer multiple or that a predetermined number of the differences between adjacent carrier frequencies, of all the differences between adjacent carrier frequencies, have the relationship in integer multiple. For example, if two of the differences between adjacent carrier frequencies have the relationship in integer multiple, the central control device 3 may allow this and perform the above-described process in step S15. If three or more of the differences between adjacent carrier frequency differences have the relationship in integer multiple, the central control device 3 may not allow this but perform the above-described process of step S11 again.

Advantages of (the switching system 1 including) the central control device 3 according to the modified example will be described below, using a second comparative example. Incidentally, the second comparative example is intended to describe some of the advantages that can be achieved by the central control unit 3 according to the modified example, but the common advantages in the present arrangement and the second comparative example are not excluded from the scope of the modified example.

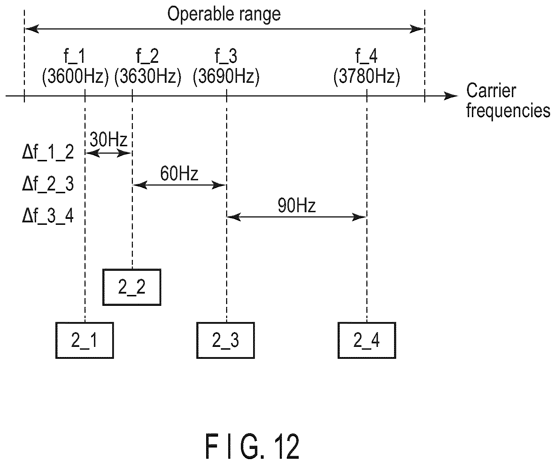

FIG. 12 is a diagram illustrating the second comparative example. In the second comparative example, it is assumed that carrier frequencies which are set such that all the differences between adjacent carrier frequencies are different from one another are assigned to four switching controllers 2_1 to 2_4 having the positional relationship shown in FIG. 12, respectively.

More specifically, the switching controller 2_1, which is adjacent to the switching controller 2_2, is assigned a carrier frequency f_1 of 3,600 Hz. The switching controller 2_2, which is adjacent to the switching controllers 2_1 and 2_3, is assigned a carrier frequency f_2 of 3,630 Hz. The switching controller 2_3, which is adjacent to the switching controllers 2_2 and 2_4, is assigned a carrier frequency f_3 of 3,690 Hz. The switching controller 2_4, which is adjacent to the switching controller 2_3, is assigned a carrier frequency f_4 of 3,780 Hz. In other words, in the second comparative example, as shown in FIG. 12, it is assumed that the difference Δf_1_2 between the carrier frequencies assigned to the adjacent switching controllers 2_1 and 2_2, and the difference Δf_2_3 between the carrier frequencies assigned to the adjacent switching controllers 2_2 and 2_3, have the relationship in integer multiple (in this case, two times). In addition, in the second comparative example, as shown in FIG. 12, it is assumed that the difference Δf_1_2 between the carrier frequencies assigned to the adjacent switching controllers 2_1 and 2_2, and the difference Δf_3_4 between the carrier frequencies assigned to the adjacent switching controllers 2_3 and 2_4, have the relationship in integer multiple (in this case, three times).

In this case, the four switching controllers 2_1 to 2_4 generate the noise enhancement effect in a cycle that is the reciprocal of the greatest common divisor of the difference between adjacent carrier frequencies. In other words, in this case as well, the electromagnetic noise emitted from the switching controllers 2_1 to 2_4 generate a noise enhancement effect of mutually interfering and strengthening each other in a cycle of approximately 0.033 seconds, similarly to the above-described case shown in FIG. 7.

In contrast, in the switching system 1 according to the modified example, the carrier frequencies, which are set such that all the differences between adjacent carrier frequencies are not only different, but the pair of differences between adjacent carrier frequencies having the relationship in integer multiple does not exist among all the differences between adjacent carrier frequencies, as described above, can be assigned to the four switching controllers 2_1 to 2_4. According to this, the cycle in which the electromagnetic noises emitted from the switching controllers 2_1 to 2_4 mutually interfere and strengthen each other (i.e., the cycle in which the noise enhancement effect occurs) can be made longer than that in the second comparative example, and the electromagnetic noise per unit time can be reduced.

Alternatively, the central control device 3 according to the modified example may randomly generate the same number of carrier cycles as the number of switching controllers 2 connected to the own device, instead of performing the process of step S11 shown in FIG. 11. In this case, the central control device 3 performs the processes in steps S12 to S14 shown in FIG. 11 after converting the generated carrier cycles into the carrier frequencies. As a result, if it is confirmed that all the differences between adjacent carrier frequencies are different values and that no pairs of differences between adjacent carrier frequencies having the relationship in integer multiple exist, the central control device 3 generates the control parameter indicating the carrier cycle corresponding to each carrier frequency and supplies the control parameter to the switching controller 2.

### (Second Modified Example)

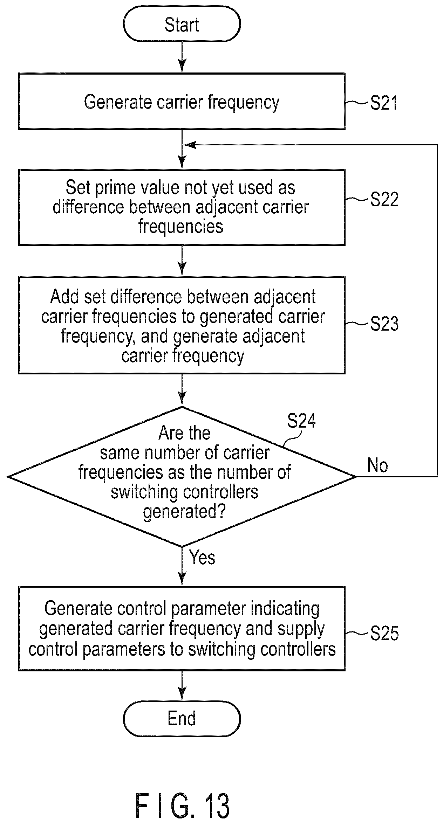

Next, a second modified example will be described. FIG. 13 is a flowchart showing an operation example of the central control device 3 according to the second modified example. Incidentally, a sequence of operations shown in FIG. 13 is performed, for example, before the plurality of switching controllers 2 connected to the central control device 3 start the operation.

First, the central control device 3 generates one carrier frequency within the range where all the plurality of switching controllers 2 connected to the own device can operate (or one carrier frequency within the range where all the plurality of switching controllers 2 that may cause the noise enhancement effect can operate) (step S21).

For example, the central control device 3 generates one carrier frequency randomly using a random number generator. Incidentally, the carrier frequencies within the range where all of the plurality of switching controllers 2 can operate vary depending on, for example, the performance of the switching controllers 2.

Then, the central control device 3 sets a prime value which has not yet been used, as the difference between adjacent carrier frequencies, to generate a carrier frequency adjacent to the generated carrier frequency (adjacent carrier frequency) (step S22). After that, the central control device 3 adds the difference between adjacent carrier frequencies, which is set in the process of step S22, to the carrier frequency generated in the process of step S21 to generate the above-described adjacent carrier frequency (step S23).

Next, the central control device 3 confirms whether the same number of carrier frequencies as the number of the plurality of switching controllers 2 connected to the own device have been generated (step S24).

If it is confirmed in step S24 that the same number of carrier frequencies as the number of switching controllers 2 connected to the own device have not yet been generated (No in step S24), the above-described process of step S22 is performed again using the adjacent carrier frequency generated in step S23 as one new carrier frequency.

In contrast, if it is confirmed in the process of step S24 that the same number of carrier frequencies as the number of switching controllers 2 connected to the own device have been generated (Yes in step S24), the central control device 3 assigns each carrier frequency generated in the processes of steps S21 to S23 to the plurality of switching controllers 2 connected to the own device in order. After that, the central control device 3 generates a control parameter indicating the assigned carrier frequency for each switching controller 2, supplies the control parameters to the switching controllers 2 (step S25) and ends the series of operations.

Incidentally, the central control device 3 may perform the series of operations shown in FIG. 13 at each preset time interval to update the control parameters supplied to each switching controller 2.

Alternatively, the central control device 3 according to the modified example may randomly generate one carrier cycle, instead of performing the process of step S21 shown in FIG. 13. In this case, the central control device 3 performs the processes in steps S22 to S24 shown in FIG. 13 after converting the generated carrier cycle into the carrier frequency. As a result, if it is confirmed that the same number of carrier frequencies as the number of switching controllers 2 connected to the own device have been generated, the central control device 3 generates the control parameters indicating the carrier cycles corresponding to the respective carrier frequencies, and supplies the control parameters to the switching controllers 2.

According to the central control device 3 of the modified example, the carrier frequencies which are set such that all the differences between adjacent carrier frequencies are different, that no pairs of the differences between adjacent carrier frequencies having the relationship in integer multiple exist among all the differences between adjacent carrier frequencies, and that each of the differences between adjacent carrier frequencies becomes a prime value having no positive common divisors other than 1, can be assigned to the plurality of switching controllers 2 connected to the own device. According to this, the cycle in which the electromagnetic noises emitted from the plurality of switching controllers 2 connected to the own device mutually interfere and strengthen each other (i.e., the cycle in which the noise enhancement effect occurs) can be made longer, and the electromagnetic noise per unit time can be reduced.

In this arrangement described above, it is assumed that the central control device 3 sets the carrier frequency of the switching controller 2 in units of 1 Hz, but it is not limited to this, and the central control device 3 may set the carrier frequency of the switching controller 2 in finer units (for example, in units of 0.1 Hz) . According to this, the inverse of the greatest common divisor of the difference between adjacent carrier frequencies can be larger than in the case of setting in units of 1 Hz, thus making it possible to lengthen the period of occurrence of the noise enhancement effect described above and to reduce the electromagnetic noise per unit time more.

According to the above-described arrangement, the control device, the system and the storage medium capable of suppressing observation of the increase in electromagnetic noise generated due to switching operations can be provided.

While certain arrangements have been described, these arrangements have been presented by way of example only, and are not intended to limit the scope of the claims. Indeed, the control device, the system and the storage medium described herein may be embodied in a variety of other forms; furthermore, various omissions, substitutions and changes in the form of the control device, the system and the storage medium described herein may be made.

The arrangements as described above include clauses below.

### Clause 1

A control device connected to at least three or a plurality of switching controllers converting AC signals into DC signals and outputting the DC signals or converting DC signals into AC signals and outputting the AC signals, characterized in that
the control device is configured to:
generate the same number of carrier frequencies as the switching controllers,
rearrange the generated carrier frequencies in ascending or descending order and calculate a difference between two adjacent carrier frequencies among the generated carrier frequencies, and
if all the calculated differences between adjacent carrier frequencies are different, set one of the generated carrier frequencies as the carrier frequency of one of the switching controllers in order.

### Clause 2

The control device of Clause 1, characterized in that
the control device is configured to, if all the calculated differences between adjacent carrier frequencies are different and if a pair of differences between adjacent carrier frequencies having a relationship in integer multiple does not exist among the calculated differences between adjacent carrier frequencies, set one of the generated carrier frequencies as the carrier frequency of one of the switching controllers in order.

### Clause 3

The control device of Clause 1, characterized in that
the control device is configured to, if all the calculated differences between adjacent carrier frequencies are different and if each of the calculated differences between adjacent carrier frequencies is a prime value, set one of the generated carrier frequencies as the carrier frequency of one of the switching controllers in order.

### Clause 4

The control device of Clause 1, characterized in that
the control device is configured to:
calculate all the differences between the generated carrier frequencies, and
if all the calculated differences between the generated carrier frequencies are different, set one of the generated carrier frequencies as the carrier frequency of one of switching controllers in order.

### Clause 5

The control device of Clause 1, characterized in that
the control device is configured to update the carrier frequency set on each of the switching controllers at each preset time interval.

### Clause 6

A system characterized by comprising:
at least three or a plurality of switching controllers converting AC signals into DC signals and outputting the DC signals or converting DC signals into AC signals and outputting the AC signals; and
a control device connected to the plurality of switching controllers, characterized in that
the control device is configured to:
   generate the same number of carrier frequencies as the switching controllers,
   rearrange the generated carrier frequencies in ascending or descending order and calculate a difference between two adjacent carrier frequencies among the generated carrier frequencies, and
   if all the calculated differences between adjacent carrier frequencies are different, set one of the generated carrier frequencies as the carrier frequency of one of the switching controllers in order.

### Clause 7

A non-transitory computer-readable storage medium storing instructions executed by a computer of a control device connected to at least three or a plurality of switching controllers converting AC signals into DC signals and outputting the DC signals or converting DC signals into AC signals and outputting the AC signals, characterized in that the instructions, when executed by the computer, cause the computer to perform:
generating the same number of carrier frequencies as the switching controllers;
rearranging the generated carrier frequencies in ascending or descending order and calculating a difference between two adjacent carrier frequencies among the generated carrier frequencies; and
if all the calculated differences between adjacent carrier frequencies are different, setting one of the generated carrier frequencies as the carrier frequency of one of the switching controllers in order.

## Claims

1. A control device (3) connected to at least three or a plurality of switching controllers (2_1, 2_2, 2_3, 2_4) converting AC signals into DC signals and outputting the DC signals or converting DC signals into AC signals and outputting the AC signals, **characterized in that**
the control device (3) is configured to:
generate the same number of carrier frequencies (f_1, f_2, f_3, f_4) as the switching controllers (2_1, 2_2, 2_3, 2_4),
rearrange the generated carrier frequencies (f_1, f_2, f_3, f_4) in ascending or descending order and calculate a difference (Δf_1_2, Δf_2_3, Δf_3_4) between two adjacent carrier frequencies among the generated carrier frequencies (f_1, f_2, f_3, f_4), and
if all the calculated differences (Δf_1_2, Δf_2_3, Δf_3_4) between adjacent carrier frequencies are different, set one of the generated carrier frequencies (f_1, f_2, f_3, f_4) as the carrier frequency of one of the switching controllers (2_1, 2_2, 2_3, 2_4) in order.

2. The control device (3) of claim 1, **characterized in that**
the control device (3) is configured to, if all the calculated differences (Δf_1_2, Δf_2_3, Δf_3_4) between adjacent carrier frequencies are different and if a pair of differences between adjacent carrier frequencies having a relationship in integer multiple does not exist among the calculated differences (Δf_1_2, Δf_2_3, Δf_3_4) between adjacent carrier frequencies, set one of the generated carrier frequencies (f_1, f_2, f_3, f_4) as the carrier frequency of one of the switching controllers (2_1, 2_2, 2_3, 2_4) in order.

3. The control device (3) of claim 1, **characterized in that**
the control device (3) is configured to, if all the calculated differences (Δf_1_2, Δf_2_3, Δf_3_4) between adjacent carrier frequencies are different and if each of the calculated differences (Δf_1_2, Δf_2_3, Δf_3_4) between adjacent carrier frequencies is a prime value, set one of the generated carrier frequencies (f_1, f_2, f_3, f_4) as the carrier frequency of one of the switching controllers (2_1, 2_2, 2_3, 2_4) in order.

4. The control device (3) of claim 1, **characterized in that**
the control device (3) is configured to:
calculate all the differences (Δf_1_2, Δf_2_3, Δf_3_4, Δf_1_3, Δf_2_4, Δf_1_4) between the generated carrier frequencies (f_1, f_2, f_3, f_4), and
if all the calculated differences (Δf_1_2, Δf_2_3, Δf_3_4, Δf_1_3, Δf_2_4, Δf_14) between the generated carrier frequencies (f_1, f_2, f_3, f_4) are different, set one of the generated carrier frequencies (f_1, f_2, f_3, f_4) as the carrier frequency of one of switching controllers (2_1, 2_2, 2_3, 2_4) in order.

5. The control device (3) of claim 1, **characterized in that**
the control device (3) is configured to update the carrier frequency set on each of the switching controllers (2_1, 2_2, 2_3, 2_4) at each preset time interval.

6. A system (1) **characterized by** comprising:
at least three or a plurality of switching controllers (2_1, 2_2, 2_3, 2_4) converting AC signals into DC signals and outputting the DC signals or converting DC signals into AC signals and outputting the AC signals; and
a control device (3) connected to the plurality of switching controllers (2_1, 2_2, 2_3, 2_4), **characterized in that**
the control device (3) is configured to:
generate the same number of carrier frequencies (f_1, f_2, f_3, f_4) as the switching controllers (2_1, 2_2, 2_3, 2_4),
rearrange the generated carrier frequencies (f_1, f_2, f_3, f_4) in ascending or descending order and calculate a difference (Δf_1_2, Δf_2_3, Δf_3_4) between two adjacent carrier frequencies among the generated carrier frequencies (f_1, f_2, f_3, f_4), and
if all the calculated differences (Δf_1_2, Δf_2_3, Δf_3_4) between adjacent carrier frequencies are different, set one of the generated carrier frequencies (f_1, f_2, f_3, f_4) as the carrier frequency of one of the switching controllers (2_1, 2_2, 2_3, 2_4) in order.

7. A non-transitory computer-readable storage medium storing instructions executed by a computer of a control device (3) connected to at least three or a plurality of switching controllers (2_1, 2_2, 2_3, 2_4) converting AC signals into DC signals and outputting the DC signals or converting DC signals into AC signals and outputting the AC signals, **characterized in that** the instructions, when executed by the computer, cause the computer to perform:
generating the same number of carrier frequencies (f_1, f_2, f_3, f_4) as the switching controllers (2_1, 2_2, 2_3, 2_4);
rearranging the generated carrier frequencies (f_1, f_2, f_3, f_4) in ascending or descending order and calculating a difference (Δf_1_2, Δf_2_3, Δf_3_4) between two adjacent carrier frequencies among the generated carrier frequencies (f_1, f_2, f_3, f_4); and
if all the calculated differences (Δf_1_2, Δf_2_3, Δf_3_4) between adjacent carrier frequencies are different, setting one of the generated carrier frequencies (f_1, f_2, f_3, f_4) as the carrier frequency of one of the switching controllers (2_1, 2_2, 2_3, 2_4) in order.
